# EUROPEAN PATENT SPECIFICATION

(11) **EP 1 722 412 B1**
(45) Date of publication and mention of the grant of the patent: **29.08.2012**
(21) Application number: 06008113.0
(22) Date of filing: 19.04.2006
(51) Int. Cl.: H01L 23/46, B05B 17/06, G06F 1/20

(54) **Jet generator and electronic device**
Sprühstrahlvorrichtung mit entsprechendem elektronischen Gerät
Système de jet d' atomisation et dispositif electronique associé

(30) Priority: 02.05.2005 JP 2005134302
(43) Date of publication of application: 15.11.2006
(73) Proprietor: Sony Corporation, Tokyo (JP)
(72) Inventor: Yokomizo, Kanji, Minato-ku, Tokyo (JP); Ishikawa, Hiroichi, Minato-ku, Tokyo (JP); Makino, Takuya, Minato-ku, Tokyo (JP); Nakayama, Norikazu, Minato-ku, Tokyo (JP); Mukasa, Tomoharu, Minato-ku, Tokyo (JP)
(74) Representative: Müller - Hoffmann & Partner

(56) References cited:
- US-A- 3 373 752
- US-A- 4 350 838
- US-A1- 2005 056 030
- US-B1- 6 367 470

## Description

### BACKGROUND OF THE INVENTION

### 1. Field of the Invention

The present invention relates to jet generators for generating gas jets and electronic devices including the jet generators.

### 2. Description of the Related Art

Increased performance of personal computers (PCs) has posed the problem of increased amounts of heat generated from heat sources such as integrated circuits (ICs). Accordingly, a wide variety of heat dissipation techniques have been proposed or commercialized. For example, radiation fins formed of a metal such as aluminum are brought into contact with an IC to transmit heat from the IC to the fins and dissipate it. In addition, a fan is used to forcibly eject warm air in a PC casing and introduce ambient cool air to the vicinity of a heat source. Furthermore, a fan and radiation fins are used in combination to forcibly eject warm air around the radiation fins with increased contact area between the air and a heat source.

The forced convection of air using a fan, however, causes a thermal boundary layer at the surfaces of radiation fins on the downstream side thereof. The thermal boundary layer undesirably makes it difficult to draw heat away from the radiation fins effectively. One of the possible solutions to this problem is to increase the air velocity of the fan to reduce the thickness of the thermal boundary layer. However, increasing the number of revolutions of the fan for increased air velocity undesirably causes noise, such as noise from a fan bearing and wind noise due to wind from the fan.

Japanese Unexamined Patent Application Publication Nos. 2000-223871, 2000-114760, 2-213200, and 3-116961, for example, disclose methods for efficiently dissipating heat from radiation fins to the outside air by breaking the thermal boundary layer without using a fan as an air blower. These methods involve the use of a diaphragm that reciprocates periodically. In particular, Japanese Unexamined Patent Application Publication Nos. 2-213200 and 3-116961 disclose devices including a diaphragm that separates the space in a chamber substantially in half, an elastic member disposed in the chamber so as to support the diaphragm, and means for vibrating the diaphragm. The diaphragm, when displaced upward, decreases the volume of the upper space of the chamber to increase the pressure therein. The increased pressure in the upper space forces part of the air contained therein into the outside air. The upper space communicates with the outside air through inlet/outlet openings. At the same time, the diaphragm increases the volume of the lower space, opposite the upper space across the diaphragm, to decrease the pressure therein. The decreased pressure in the lower space forces part of the outside air into the lower space. The lower space communicates with the outside air through inlet/outlet openings. When displaced downward, on the other hand, the diaphragm increases the volume of the upper space of the chamber to decrease the pressure therein. The decreased pressure in the upper space forces part of the outside air into the upper space through the inlet/outlet openings. At the same time, the diaphragm decreases the volume of the lower space to increase the pressure therein. The increased pressure in the lower space forces part of the air contained therein into the outside air through the inlet/outlet openings. The diaphragm is, for example, electromagnetically actuated. The diaphragm thus reciprocates and periodically repeats the ejection of the air contained in the chamber to the outside air and the suction of the outside air into the chamber. The periodic reciprocating motion induces a pulsating air jet which impinges on a heat source such as radiation fins (heatsink). The pulsating air jet efficiently breaks a thermal boundary layer on the surface of the heat source, thus efficiently cooling the heat source.

US-A-6.367.470 discloses a nebuliser which comprises means for determining the duration of a pulse of atomisation during inspiration, wherein the determination means include means for measuring the tidal volume of a patient, timing means for measuring the duration of inspiration, means for storing an estimate of the volume of a patient's upper airway, and means for calculating the duration of the pulse on the basis of the tidal volume measured by the tidal volume measuring means, the duration of inspiration measured by the timing means, and the stored estimated volume of a patient's upper airway from the storage means.

US-A-3.373.752 discloses a method for cleaning a surface by directing a highpressure stream of liquid/gas mixture from a nozzle against the surface, wherein ultrasonic vibrations are imparted to the mixture in the nozzle by an electrochemical transducer. By serrating areas on the internal tapered wall of the nozzle the transfer of vibrational energy to the liquid can be augmented.

US-A-4,350,838 is directed to a vapor-cooled power transformer, wherein a transformer is provided within a sealed housing, and means for applying ultrasonic vibrations to a dielectric liquid within the housing are provided in order to vaporize the fluid and to apply it to the exposed surfaces of the transformer.

US-A-2005/00560030 deals with a semiconductor chip cooling system comprising a sprayer delivery system with an actuator controlled by a controller. The controller uses sensors that sense the temperature of the hot components.

### SUMMARY OF THE INVENTION

In recent years, the amounts of heat generated from ICs have been rising with increasing clock speed. Accordingly, for example, a larger amount of air supply is demanded for ICs and radiation fins to break a thermal boundary layer caused near the fins after heat generation. In air ejection techniques using a diaphragm that reciprocates periodically as disclosed in the above publications, the amount of air ejected can be increased by increasing the amplitude of vibration of the diaphragm. If the amplitude of vibration is increased, however, the vibration of the diaphragm is undesirably transmitted through, for example, a casing of a jet generator and a casing of an electronic device including the jet generator.

This problem arises from a vibrational force produced by the reciprocating motion of the diaphragm, which has weight, and an actuator that actuates the diaphragm. The transmission of vibration can be reduced by, for example, decreasing the weight or amplitude of vibration of the diaphragm or the frequency used. However, there are trade-offs between the reduction in the weight of the diaphragm and the maintenance of the strength thereof and between the reduction in amplitude of vibration and frequency and the increase in the amount of air ejected for increased cooling efficiency (the amount of air ejected is proportional to the product of the amplitude of vibration, the effective cross-sectional area, and the frequency).

Accordingly, it is desirable to provide a jet generator that can inhibit the transmission of vibration to the outside thereof without decreasing the amount of gas ejected or cooling capability and also provide an electronic device including the jet generator.

A jet generator according to an embodiment of the present invention includes at least one casing containing a gas and having an opening, vibrators, wherein at least one of the vibrators is attached to the at least one casing, and actuators for actuating the vibrators. The vibrators are so adjusted that the vibrational forces thereof attenuate each other, thereby vibrating the gas to eject a pulsating jet thereof through the opening.

This jet generator can inhibit the transmission of vibration to the outside of the casing or the jet generator because the vibrators vibrate with the vibrational forces thereof being synthesized so as to attenuate each other. In addition, the jet generator can avoid a decrease in the amount of gas ejected, or rather can increase it, because the vibrational forces attenuate each other even for increased amplitudes of vibration.

For example, at least one of the mass, structure, amplitude of vibration, and phase of the vibrators may be adjusted so that the vibrational forces attenuate each other. Alternatively, the vibrators may be arranged in such a manner that the vibrational forces attenuate each other, as described later.

The vibrators may be arranged in any manner that allows the vibrational forces thereof to attenuate each other after synthesis. For example, the vibrators may be arranged in the vibration direction or perpendicularly thereto. In addition, the vibrators may be arranged in three dimensions. For example, three vibrators may be arranged with the vibration directions thereof tilted 120° from each other (such that they define, for example, a triangular prism), or four vibrators may be arranged with the vibration directions thereof tilted 90° from each other (such that they define, for example, a rectangular parallelepiped). The term "vibration direction" herein is unrelated to phase; this term represents the direction of reciprocating motion, namely vibration, and is hereinafter used with this meaning.

Although the gas used is typically air, other gases may also be used, including nitrogen gas, helium gas, and argon gas.

The actuators may actuate the vibrators with, for example, an electromagnetic effect, a piezoelectric effect, or an electrostatic effect.

The vibrators may have a three-dimensional structure, rather than a flat structure. Such vibrators are exemplified by those having side plates or ribs for increasing rigidity, although any three-dimensional structure may be used for any purpose. Examples of the shape of the vibrators in a plane perpendicular to the vibration direction include a circle, an ellipse, and a rectangle.

In this embodiment, two of the vibrators may face each other and be actuated by the actuators so as to move toward and away from each other. This allows the vibrational forces to attenuate each other. In this case, the vibrators may, for example, have different sizes, have different shapes, or be formed of different materials.

In this embodiment, preferably, the vibrators have the same size and shape, are formed of the same material, and vibrate with the same frequency, and the actuators actuate the vibrators with a phase difference of substantially 360/n° from each other where n is the number of the vibrators. This allows the vibrational forces to attenuate each other. The same size, shape, and material described above mean sizes, shapes, and materials, respectively, that are sufficiently similar to achieve the embodiment of the present invention, that is, that can be construed as being substantially identical in terms of mass production, rather than as being physically completely identical.

This embodiment preferably meets the following conditions: the number of the vibrators is at least three; the vibrators have the same size and shape, are formed of the same material, and vibrate with the same frequency; a first vibrator group including at least two of the vibrators is actuated to vibrate at a first phase; the sum of the amplitudes of vibration of the first vibrator group is a first amplitude of vibration; at least one of the vibrators other than the first vibrator group is actuated to vibrate at a second phase opposite the first phase; and the sum of the amplitude of vibration of the at least one vibrator is a second amplitude of vibration equal to the first amplitude of vibration. The vibration of the vibrators may thus be controlled so that the vibrational forces thereof attenuate each other after synthesis.

In this embodiment, at least two of the vibrators may differ in at least one of size, shape, and material. Even if the jet generator includes two or more different types of vibrators, the amplitudes of vibration or phases thereof, for example, may be controlled so that the vibrational forces thereof attenuate each other after synthesis.

In this embodiment of the present invention more than one casing may be provided that contains a gas and each has an opening, the vibrators are attached to the individual casings, and actuators are disposed in the individual casings to actuate the vibrators.

This jet generator can inhibit the transmission of vibration to the outside of the casings or the jet generator because the vibrators vibrate with the vibrational forces thereof being synthesized so as to attenuate each other. Each of the casings may have a single opening or a plurality of openings.

In this embodiment, preferably, the number of the vibrators is at least three, a first vibrator group including at least two of the vibrators is actuated to vibrate at a first phase in a first direction, and at least one of the vibrators other than the first vibrator group is actuated to vibrate at a second phase opposite the first phase in the first direction. The vibrators do not necessarily have to have the same size and shape or be formed of the same material, and may be arranged and actuated by the actuators 5 so that the vibrational forces thereof attenuate each other.

In this embodiment, preferably, the vibrators vibrate in the same direction, and the casings are arranged in the vibration direction. In this case, at least two of the vibrators vibrate at different phases in the same direction. This allows effective ejection of the gas toward objects, such as heat sources, arranged in one or two dimensions in a plane including the vibration direction. Alternatively, preferably, the vibrators vibrate in the same direction, and the casings are arranged in a plane substantially perpendicular to the vibration direction. This allows the ejection of the gas toward objects, such as heat sources, arranged in one or two dimensions in the plane substantially perpendicular to the vibration direction.

In this embodiment, the casings may have engaging portions that engage with each other. These engaging portions allow the casings to be stacked on top of each other or to be arranged in a plane according to the shapes and positions of objects of interest, such as heat sources, to achieve, for example, effective heat dissipation.

An electronic device according to another embodiment of the present invention includes a heat source, at least one jet generator casing containing a gas and having an opening, vibrators wherein at least one of the vibrators is attached to the at least one casing, and actuators for actuating the vibrators. The vibrators are so adjusted that the vibrational forces thereof attenuate each other, thereby vibrating the gas to eject a pulsating jet thereof through the opening toward the heat source.

In this embodiment of the present invention more than one jet generator casing may be provided that contains a gas and each has an opening, wherein the vibrators are attached to the individual casings, and the actuators are disposed in the individual jet generator casings to actuate the vibrators.

Examples of the electronic devices include computers (such as laptop PCs and desktop PCs), personal digital assistants (PDAs), electronic dictionaries, cameras, displays, audio/video equipment, cellular phones, game machines, and other electrical appliances. The heat source may be any object that releases heat. Examples of the heat source include, though not limited to, electronic components such as ICs and resistors and radiation fins (heatsinks).

The jet generators and the electronic devices according to the embodiments described above can inhibit the transmission of vibration to the outside of the jet generators without decreasing the amount of gas ejected or cooling capability.

### BRIEF DESCRIPTION OF THE DRAWINGS

Fig. 1 is a perspective view of a jet generator according to an embodiment of the present invention;
Fig. 2 is a sectional view of the jet generator shown in Fig. 1;
Fig. 3 is a graph showing how diaphragms vibrate with the vibrational forces thereof attenuating each other;
Fig. 4 is a sectional view of a jet generator according to another embodiment of the present invention;
Fig. 5 is a sectional view of a jet generator according to another embodiment of the present invention;
Fig. 6 is a sectional view of a jet generator according to another embodiment of the present invention;
Fig. 7 is a sectional view of a jet generator according to another embodiment of the present invention;
Fig. 8 is a graph showing variations in the amplitudes of vibration of diaphragms included in jet-generating units;
Fig. 9 is another graph showing variations in the amplitudes of vibration of the diaphragms included in the jet-generating units;
Fig. 10 is a sectional view of a jet generator according to another embodiment of the present invention;
Figs. 11A and 11B are sectional views of jet generators that inhibit the occurrence of a moment according to other embodiments of the present invention;
Figs. 12A to 12F are schematic diagrams of jet generators including jet-generating units according to other embodiments of the present invention;
Figs. 13A to 13F are schematic diagrams of jet generators including diaphragms in a single casing according to other embodiments of the present invention;
Figs. 14A to 14F are schematic diagrams of electronic devices including jet generators according to other embodiments of the present invention;
Figs. 15A to 15F are schematic diagrams illustrating the relative positions of heat sources and jet-generating units in other embodiments of the present invention;
Figs. 16A and 16B are sectional views of an electronic device including a casing integrated with casings of jet-generating units according to another embodiment of the present invention;
Figs. 17A and 17B are sectional view of casings of jet-generating units stacked on top of each other according to another embodiment of the present invention;
Fig. 18 is a bottom view of the casing of each jet-generating unit shown in Fig. 17A;
Fig. 19 is a sectional view of casings according to a modification of the embodiment shown in Fig. 17B;
Fig. 20 is a sectional view of an electronic device including the jet generator shown in Fig. 10 according to another embodiment of the present invention;
Fig. 21 is a sectional view of an electronic device including the jet generator shown in Fig. 10 according to another embodiment of the present invention;
Fig. 22 is a sectional view of an electronic device including the jet generator shown in Fig. 10 according to another embodiment of the present invention;
Fig. 23 is a plan view of the jet generator shown in Fig. 22;
Figs. 24A and 24B are partial side views of the electronic device shown in Fig. 22; and
Fig. 25 is a side view of an example of a movable member.

### DESCRIPTION OF THE PREFERRED EMBODIMENTS

Embodiments of the present invention will now be described with reference to the drawings.

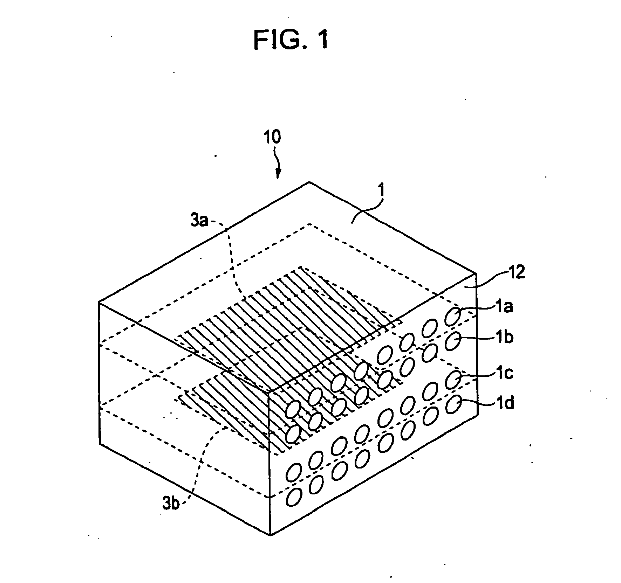

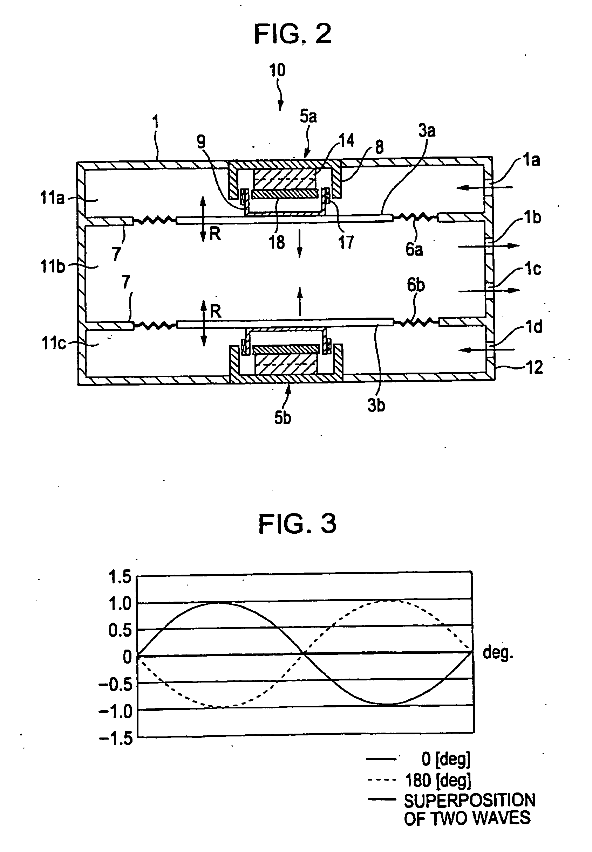

Fig. 1 is a perspective view of a jet generator according to an embodiment of the present invention. Fig. 2 is a sectional view of the jet generator.

A jet generator 10 includes a casing 1 containing air. This casing 1 has, for example, a rectangular parallelepiped shape. The casing 1 includes, for example, two opposing diaphragms 3a and 3b and actuators 5a and 5b for actuating the diaphragms 3a and 3b, respectively. For example, the actuator 5a is disposed on the top side of the casing 1, and the actuator 5b is disposed on the bottom side of the casing 1. Elastic supports 6a and 6b are attached to the peripheries of the diaphragms 3a and 3b, respectively. The elastic supports 6a and 6b are also attached to ribs 7 protruding from the inner walls of the casing 1. That is, the diaphragms 3a and 3b are attached to the elastic supports 6a and 6b so as to be vibratable with respect to the casing 1. The diaphragms 3a and 3b and the elastic supports 6a and 6b separate the space in the casing 1 into three chambers 11a, 11b, and 11c.

The chamber 11b has a larger volume than the chambers 11a and 11c. This structure, however, does not necessarily have to be employed, and the chambers 11a, 11b, and 11c may all have identical or different volumes.

Arrays of openings 1a to 1d are provided in a side surface 12 of the casing 1. The openings 1a communicate with the chamber 11a. The openings 1b and 1c communicate with the chamber 11b. The openings 1d communicate with the chamber 11c. The air contained in the chambers 11a, 11b, and 11c is ejected through the openings 1a to 1d toward a heat source (not shown) such as a heatsink.

The two actuators 5a and 5b, which have the same structure, each include, for example, a cylindrical yoke 8, a magnet 14 accommodated in the yoke 8 and magnetized in the vibration direction R of the diaphragms 3a and 3b, and a disc-shaped yoke 18 attached to the magnet 14. The magnet 14 and the yokes 8 and 18 constitute a magnetic circuit. A coil bobbin 9 having a coil 17 wound therearound moves into and out of the space between the magnet 14 and the yoke 8. That is, the actuators 5a and 5b are composed of voice coil motors. The actuators 5a and 5b are connected to drive ICs (not shown) through feed lines (not shown) connected to the coils 17. The drive ICs supply electrical signals to the actuators 5a and 5b through the feed lines to vibrate the diaphragms 3a and 3b in the vibration direction R.

The casing 1 is formed of, for example, resin, rubber, metal, or ceramic. In particular, resin and rubber are suitable for mass production because of their formability. In addition, resin and rubber can inhibit, for example, noise from the actuators 5a and 5b and jet noise due to the vibration of the diaphragms 3a and 3b. That is, if the casing 1 is formed of resin or rubber, it can inhibit the noise with high attenuation. Furthermore, these materials allow for reductions in weight and cost. Among metals, copper and aluminum are preferred for their high thermal conductivity in view of heat dissipation from the casing 1. The elastic supports 6a and 6b are formed of, for example, resin or rubber.

The diaphragms 3a and 3b are formed of, for example, resin, paper, rubber, or metal. The diaphragms 3a and 3b do not necessarily have to have a flat shape as shown in the drawings and may also have a three-dimensional shape such as a conical shape like diaphragms for loudspeakers. The planar shape (the shape in a plane substantially perpendicular to the vibration direction R) of the diaphragms 3a and 3b is not limited to the rectangular shape shown in Fig. 1; the diaphragms 3a and 3b may also have, for example, a circular shape, an elliptical shape, or a combination of a circle and a rectangle, that is, a rectangular shape with rounded corners.

The operation of the jet generator 10 is then described below.

The actuators 5a and 5b are supplied with, for example, a sinusoidal AC voltage to induce the sinusoidal vibration of the diaphragms 3a and 3b. Specifically, the actuators 5a and 5b actuate the diaphragms 3a and 3b, respectively, so that they move toward and away from each other to increase or decrease the volumes of the chambers 11a, 11b, and 11c. The changes in the volumes thereof vary the pressures therein to produce a pulsating air jet through the openings 1a to 1d. If, for example, the diaphragms 3a and 3b are displaced in such directions as to increase the volumes of the chambers 11a and 11c, respectively, the pressures in the chambers 11a and 11c decrease and the pressure in the chamber 11b increases. As a result, the air outside the casing 1 flows into the chambers 11a and 11c through the openings 1a and 1d, respectively, while the air contained in the chamber 11b is ejected to the outside of the casing 1 through the openings 1b and 1c. If, on the other hand, the diaphragms 3a and 3b are displaced in such directions as to decrease the volumes of the chambers 11a and 11c, respectively, the pressures in the chambers 11a and 11c increase so that the air contained in the chambers 11a and 11c is ejected to the outside through the openings 1a and 1d.

When the air is ejected through the openings 1a to 1d, the atmospheric pressure outside the casing 1 decreases around the openings 1a to 1d. As a result, the ambient air is drawn to the air ejected through the openings 1a to 1d to produce a synthetic jet. The synthetic jet is allowed to impinge on a heat source, such as a heatsink, and cool it.

Fig. 3 is a graph showing the attenuation by synthesis of vibrational forces produced by the vibration of the diaphragms 3a and 3b. In Fig. 3, the thin line represents variations in the amplitude of vibration of the diaphragm 3a, and the dashed line represents variations in the amplitude of vibration of the diaphragm 3b. This graph shows the variations in the amplitudes of vibration of the diaphragms 3a and 3b for the configuration shown in Fig. 2. The thick line represents the amplitude of the two superposed waves, which is ideally zero. The variations in amplitude of vibration are in phase with the variations in vibrational force because an equation describing the amplitude of vibration (Y = Asinω̃t where A is the amplitude, ω̃ is angular velocity, and t is time) is differentiated two times with respect to time to yield an equation describing acceleration. Accordingly, the variations in amplitude of vibration are proportional to the variations in vibrational force. If, therefore, the vibration of one diaphragm is out of phase with that of the other diaphragm, the vibrational forces thereof are synthesized so as to attenuate each other.

Sound waves occur in the vicinities of the openings 1a to 1d when the air is ejected to the outside through the openings 1a to 1d. These sound waves attenuate each other and result in reduced noise because the vibration of the diaphragm 3a is out of phase with that of the diaphragm 3b and thus the timing when the air is ejected through the openings 1b and 1c is out of phase with the timing when the air is ejected through the openings 1a and 1d.

The jet generator 10, as described above, can inhibit the transmission of the vibration of the diaphragms 3a and 3b to the outside of the casing 1 or the jet generator 10 because the diaphragms 3a and 3b vibrate so that the vibrational forces thereof attenuate each other. In addition, the jet generator 10 can avoid a decrease in the amount of air ejected, or rather can increase it, because the vibrational forces of the diaphragms 3a and 3b attenuate each other even for increased amplitudes of vibration.

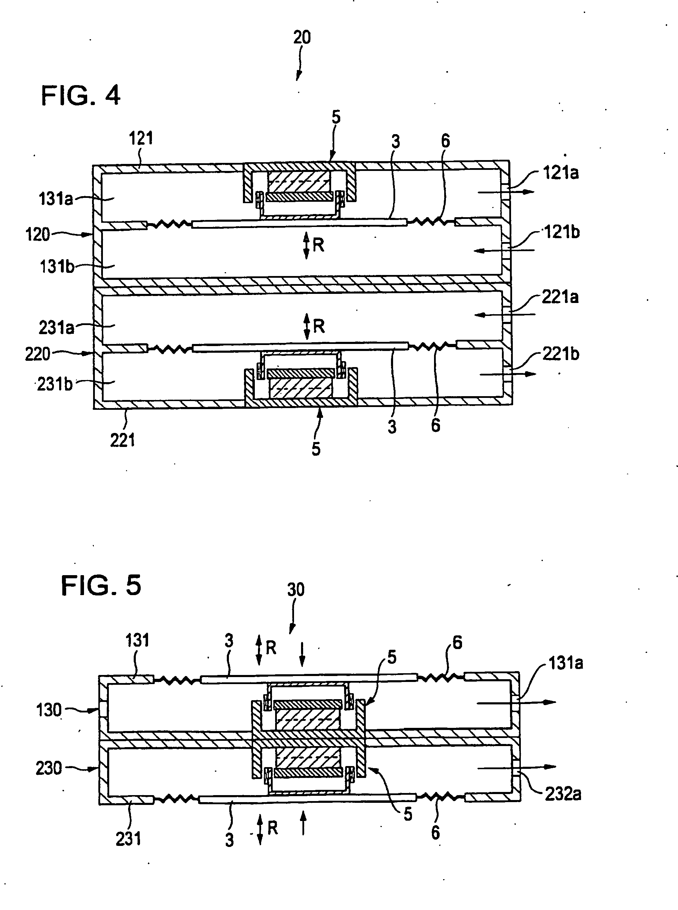

Fig. 4 is a sectional view of a jet generator according to another embodiment of the present invention. The description below will focus on differences from the jet generator 10 according to the embodiment described above, and the same members and functions, for example, as in the above embodiment are not or only briefly described.

A jet generator 20 includes a first jet-generating unit 120 and a second jet-generating unit 220 that are stacked on top of each other. The first jet-generating unit 120 includes a casing 121 accommodating a diaphragm 3 and an elastic support 6 which separate the space in the casing 121 into a first chamber 131a and a second chamber 131b. The second jet-generating unit 220 includes a casing 221 having the same structure as the casing 121 of the first jet-generating unit 120. The second jet-generating unit 220 is disposed upside down with respect to the position of the first jet-generating unit 120 with the diaphragms 3 thereof facing each other.

Actuators 5 actuate the diaphragms 3 so as to decrease the volumes of the chambers 131b and 231a while increasing the volumes of the chambers 131a and 231b. On the other hand, the actuators 5 actuate the diaphragms 3 so as to increase the volumes of the chambers 131b and 231a while decreasing the volumes of the chambers 131a and 231b. These operations eject a pulsating air jet through openings 121a, 121b, 221a, and 221b.

The two jet-generating units 120 and 220 can allow the vibrational forces of the diaphragms 3 to attenuate each other. The jet generator 20 thus has the same advantages as the jet generator 10 shown in Figs. 1 and 2.

Fig. 5 is a sectional view of a jet generator according to another embodiment of the present invention. A jet generator 30 includes two jet-generating units 130 and 230 having the same structure and arranged with the diaphragms 3 thereof facing away from each other in the vibration direction R. The jet generators 130 and 230 include casings 131 and 231, respectively, accommodating actuators 5. For example, the jet generator 30 allows the diaphragms 3 to move toward and away from each other so that the vibrational forces thereof attenuate each other.

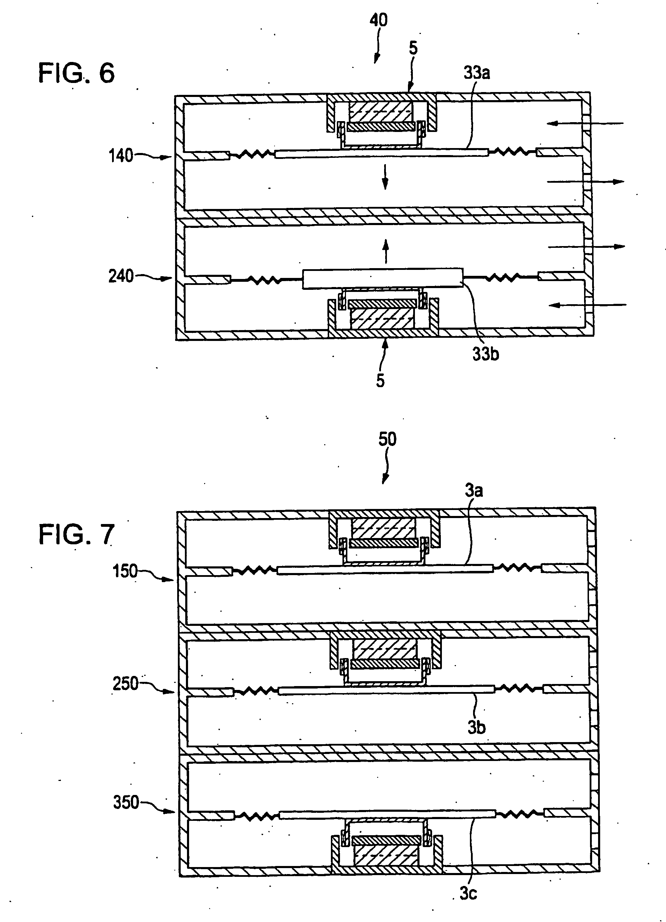

Fig. 6 is a sectional view of a jet generator according to another embodiment of the present invention. A jet generator 40 includes two jet-generating units 140 and 240 that are stacked on top of each other. This jet generator 40 differs from the jet generator 20 shown in Fig. 4 in the shape of diaphragm. In Fig. 6, a diaphragm 33b of the jet-generating unit 240, for example, is thicker than a diaphragm 33a of the jet-generating unit 140.

Even if the diaphragms 33a and 33b have different sizes, have different shapes, or are formed of different materials, for example, the diaphragms 33a and 33b may be allowed to move toward or away from each other so that the vibrational forces thereof attenuate each other after synthesis. A residual force may be left after the attenuation of the vibrational forces by synthesis. The vibrational forces may also be substantially eliminated by, for example, increasing the amplitude of vibration of the diaphragm 33a to larger than that of the diaphragm 33b, which has a larger mass than the diaphragm 33a.

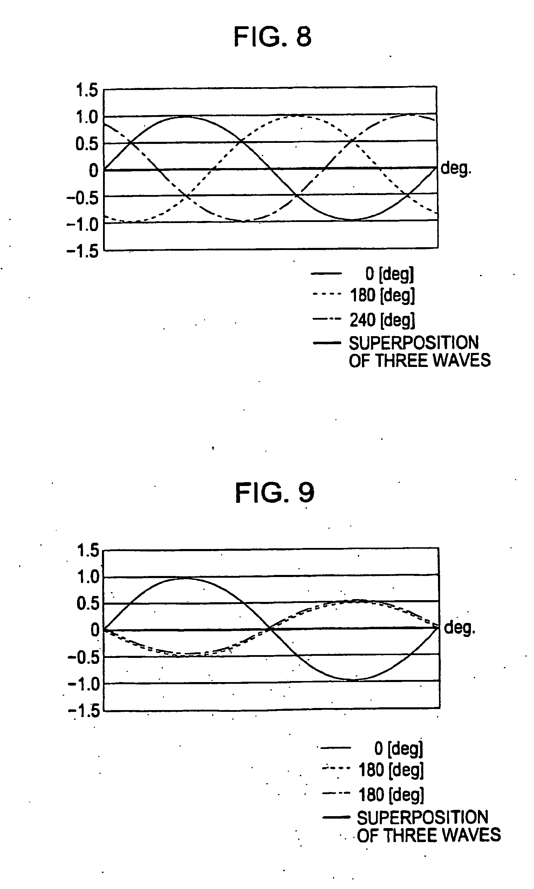

Fig. 7 is a sectional view of a jet generator according to another embodiment of the present invention. A jet generator 50 includes three jet-generating units 150, 250, and 350 stacked on top of each other and having the same structure as the jet-generating units 120 and 220 shown in Fig. 4. The jet-generating units 150 and 250 face the same direction while the jet-generating unit 350 faces the opposite direction. Fig. 8 is a graph showing variations in the amplitudes of vibration of diaphragms 3a, 3b, and 3c included in the jet-generating units 150, 250, and 350, respectively. Fig. 8 shows that the diaphragms 3a, 3b, and 3c vibrate with a phase difference of 120° from each other. As in Fig. 8, waves representing the amplitudes of vibration of n diaphragms are superposed to leave no vibrational force if the diaphragms vibrate with a phase difference of 360/n° from each other.

The three diaphragms 3a, 3b, and 3c may also vibrate as shown in Fig. 9. If one diaphragm has an amplitude of vibration of 1.0 in the graph of Fig. 9, for example, the other two diaphragms each have an amplitude of vibration of 0.5 in opposite phase.

The diaphragms 3a, 3b, and 3c preferably have the same size and shape and be formed of the same material, for example, to achieve waveforms as shown in Figs. 7 and 8.

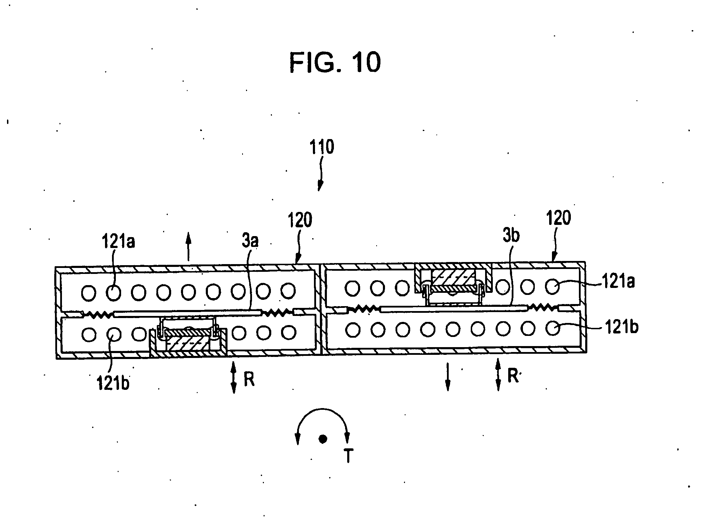

Fig. 10 is a sectional view of a jet generator according to another embodiment of the present invention. A jet generator 110 includes jet-generating units 120 (which are the same as the jet-generating unit 120 or 220 shown in Fig. 4) arranged in a plane perpendicular to the vibration direction R of diaphragms 3a and 3b. In the drawing, openings 121a and 121b are positioned so that air is ejected perpendicularly to the page. In the vibration of the jet generator 110, the diaphragm 3a moves downward when the diaphragm 3b moves upward, and vice versa. The vibrational forces of the diaphragms 3a and 3b are then synthesized and converted into a moment acting on the overall jet generator 110 in a direction indicated by arrow T. This arrangement can therefore inhibit an adverse effect on an electronic device including the jet generator 110 and can also reduce noise. It should be noted that the synthesized vibrational force is also said to be "attenuated" when the force is converted into a moment, as in this embodiment, because the conversion results in a reduction in the vibrational force acting on the overall device.

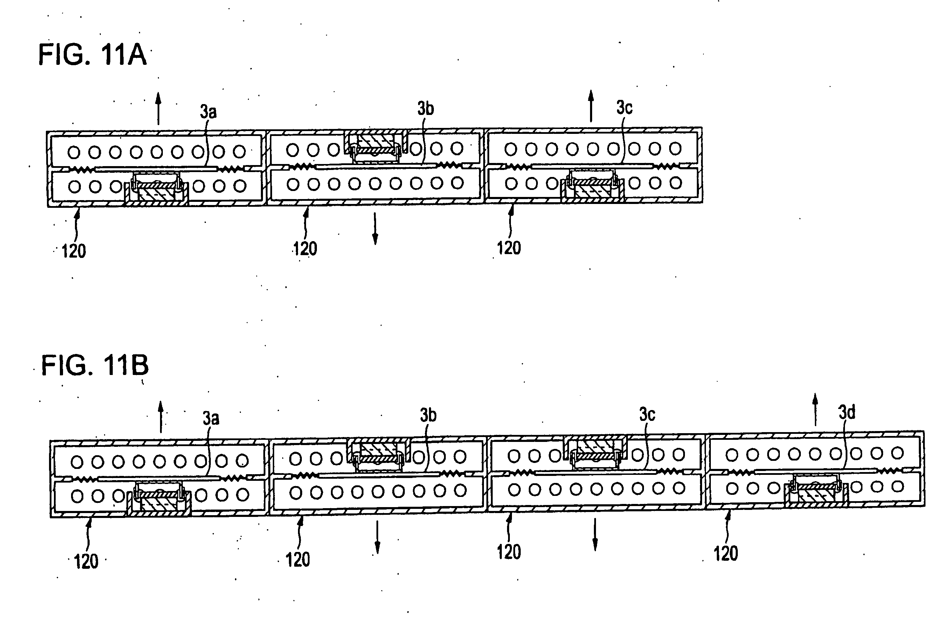

The occurrence of the moment may be inhibited by arranging at least three jet-generating units 120 longitudinally, as shown in Figs. 11A and 11B. In Fig. 11A, for example, diaphragms 3a and 3c move upward when a diaphragm 3b moves downward. If the diaphragms 3a to 3c have the same size and shape and are formed of the same material, for example, the resultant vibrational forces may be minimized by substantially balancing the synthesized vibrational force (amplitude of vibration) of the diaphragms 3a and 3c with the vibrational force (amplitude of vibration) of the diaphragm 3b. In Fig. 11B, for example, the synthesized vibrational force can be attenuated by allowing the diaphragms 3a and 3d to move upward when the diaphragms 3b and 3c move downward.

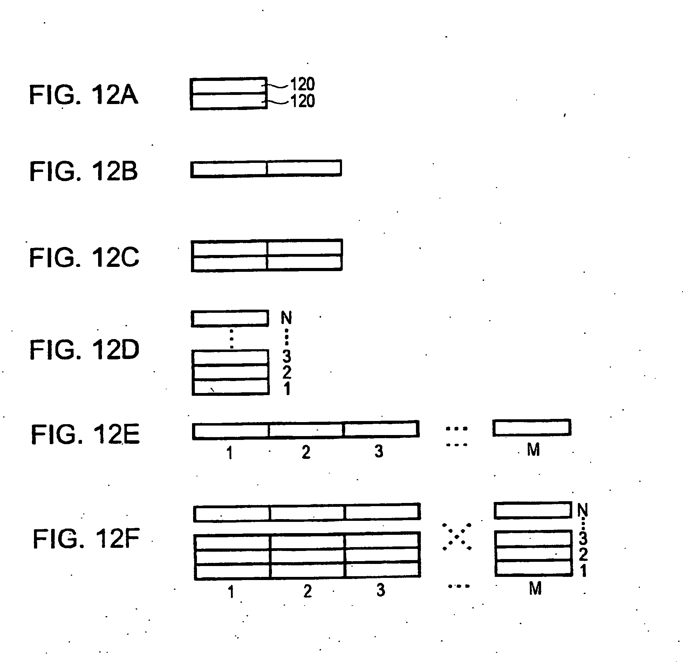

Figs. 12A to 12F are schematic diagrams of jet generators including jet-generating units. Fig. 12A shows a jet generator including jet-generating units 120 stacked on top of each other as shown in Fig. 4. Fig. 12B shows a jet generator as shown in Fig. 10. Fig. 12C shows a jet generator including jet-generating units 120 arranged in two columns and two rows. Fig. 12D shows a jet generator including n jet-generating units 120 stacked on top of each other. Fig. 12E shows a jet generator including m jet-generating units 120 arranged longitudinally. Fig. 12F shows a jet generator including jet-generating units 120 arranged in n columns and m rows. In these embodiments, the vibrational forces of diaphragms can be allowed to attenuate each other after synthesis by adjusting, for example, the amplitudes of vibration, phases, or arrangements of the diaphragms. In addition, these embodiments provide greater versatility because the jet-generating units 120, which have the same structure, can be arranged and combined according to the size and shape of a heat source of interest.

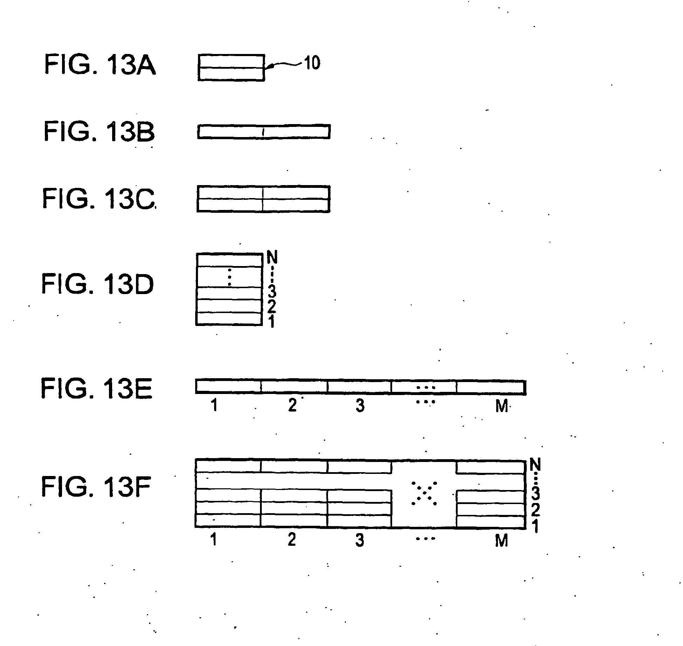

Jet generators shown in Figs. 13A to 13F according to other embodiments of the present invention are similar to those shown in Figs. 12A to 12F. The jet generators shown in Figs. 13A to 13F include a single casing accommodating diaphragms. Fig. 13A, for example, shows a jet generator as shown in Fig. 2. That is, the number of regions separated in a single casing is equal to the number of diaphragms. These embodiments can allow the resultant vibrational forces to attenuate each other after synthesis. If, particularly, a jet generator is designed for cooling a heat source of a given size, these embodiments have advantages such as reductions in the amount of material used and the size of the overall jet generator.

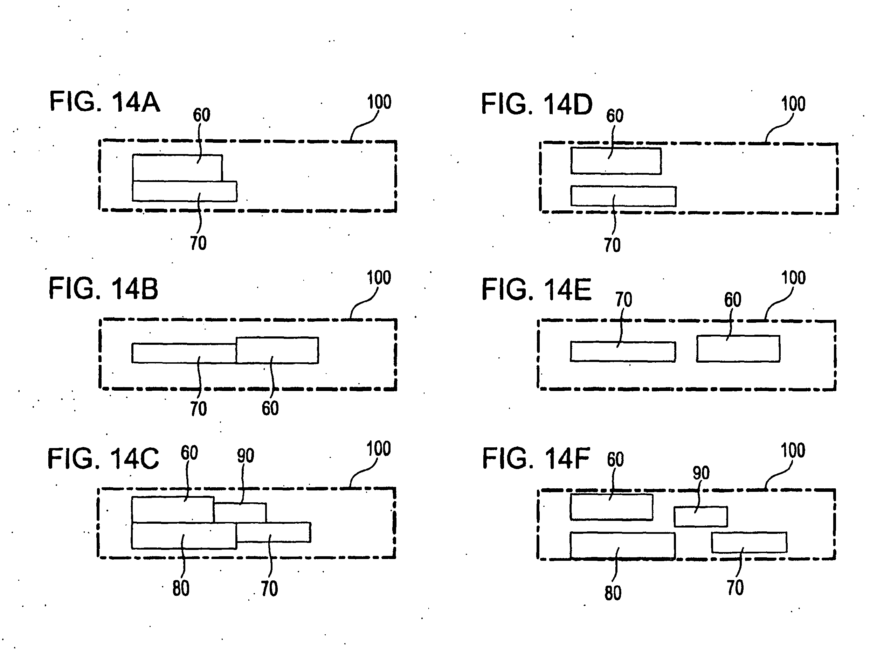

Figs. 14A to 14F are schematic diagrams of electronic devices including jet generators according to other embodiments of the present invention. Fig. 14A shows a casing 100 of an electronic device, such as a PC, and jet-generating units 60 and 70 included in the casing 100. Although the jet-generating units 60 and 70 differ in, for example, the size of casing in the drawing, they have the same basic structure and principle as those described above. The jet-generating unit 60 has the same structure as, for example, the jet-generating unit 120 shown in Fig. 4. Various arrangements of jet-generating units are permitted as exemplified in Figs. 14A to 14F.

The jet-generating units 60 and 70 (and other jet-generating units 80 and 90) are in contact with each other in Figs. 14A to 14C while they are separated from each other in Figs. 14D to 14F, in which the vibrational forces of the jet-generating units 60 and 70, for example, attenuate each other through the casing 100.

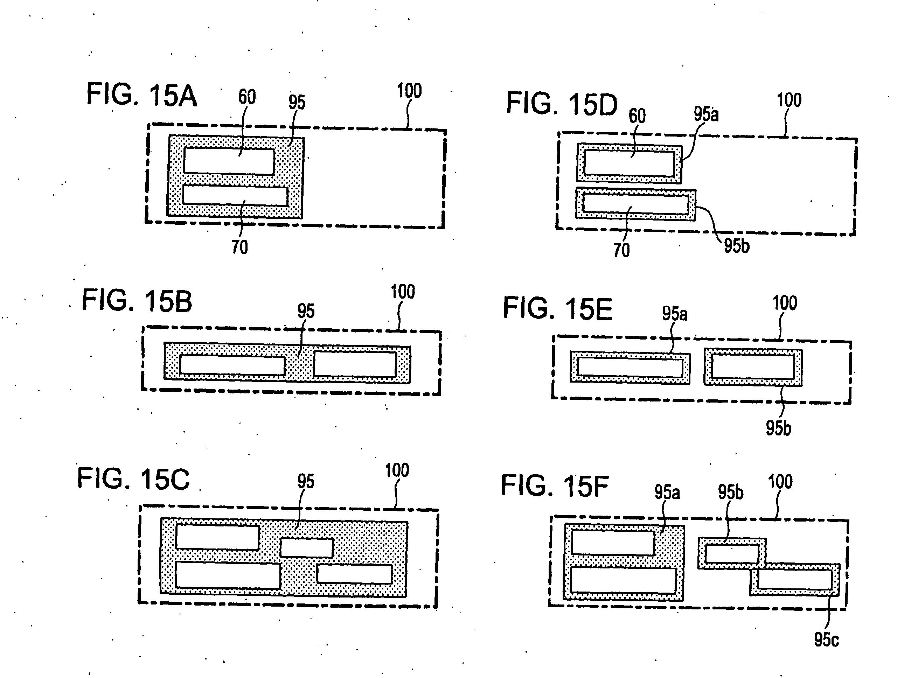

Figs. 15A to 15F are schematic diagrams illustrating the relative positions of heat sources and jet-generating units in other embodiments of the present invention. In Figs. 15A to 15C, a single heat source 95, such as a heatsink, is disposed in a casing 100 of an electronic device such as a PC. In Figs. 15D to 15F, heat sources 95a and 95b, for example, are disposed in the casing 100. Jet-generating units may be assigned to individual heat sources. Any of the arrangements shown in Figs. 15A to 15F can allow the vibrational forces to attenuate each other. The optimum arrangement may be determined with consideration given to the size of electronic devices, the capacities and arrangement of heat sources, and the sizes and capacities of jet-generating units.

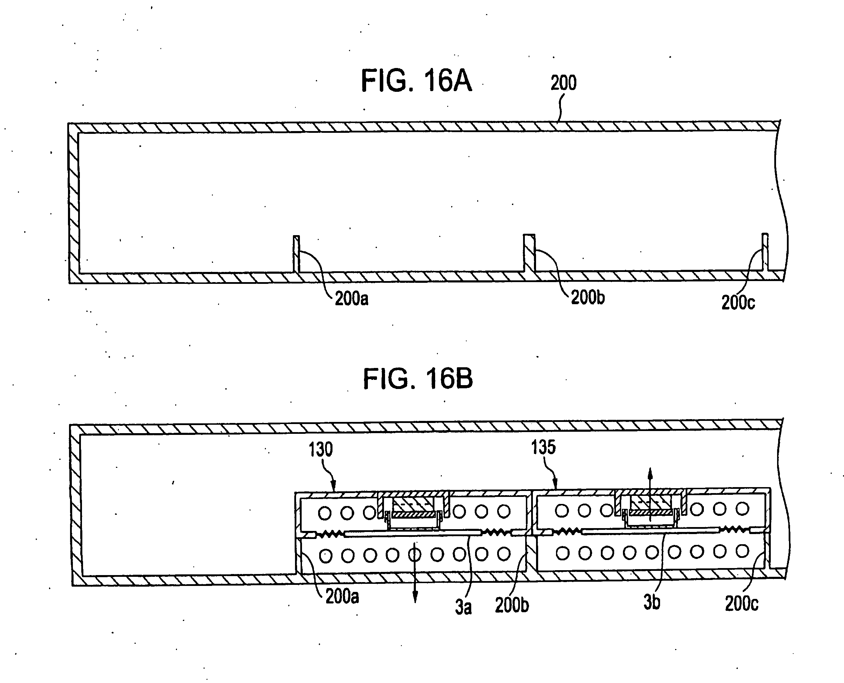

Figs. 16A and 16B are sectional views of an electronic device according to another embodiment of the present invention. This electronic device includes a casing integrated with casings of jet-generating units. In Fig. 16A, the electronic device includes a casing 200 having walls 200a, 200b, and 200c protruding from the inner bottom surface thereof. The casing 200 can be integrally formed with the walls 200a, 200b, and 200c. In Fig. 16B, jet-generating units 130 and 135 are fixed to the walls 200a, 200b, and 200c. The jet-generating units 130 and 135 have the same structure as those shown in Fig. 5. As compared to, for example, the case where the jet generator 110 shown in Fig. 10 is directly attached to the casing 200, this embodiment allows for a reduction in the thickness of the electronic device by the thickness of the casings of the jet-generating units 130 and 135. In this embodiment, a synthesized vibrational force is converted into a moment by allowing the diaphragm 3a to move downward while the diaphragm 3b moves upward.

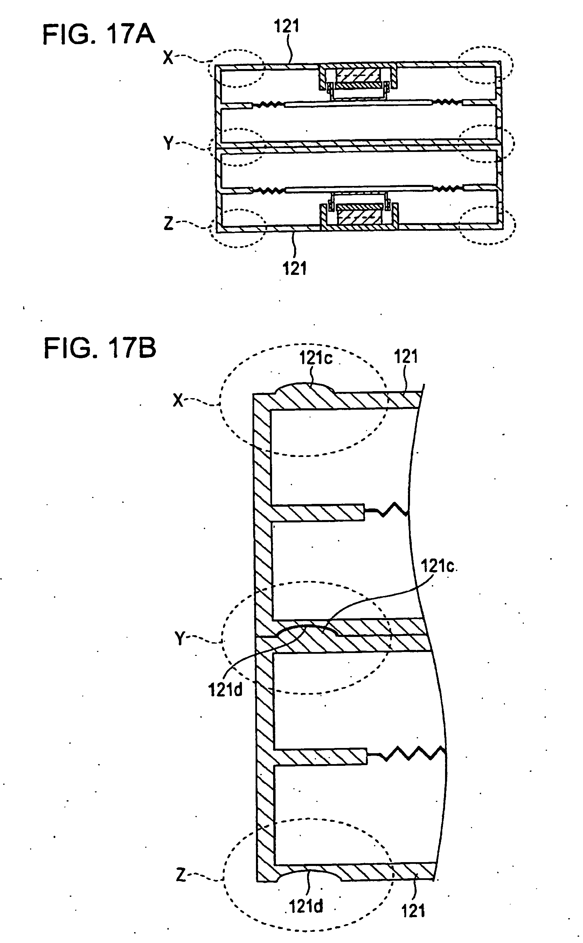

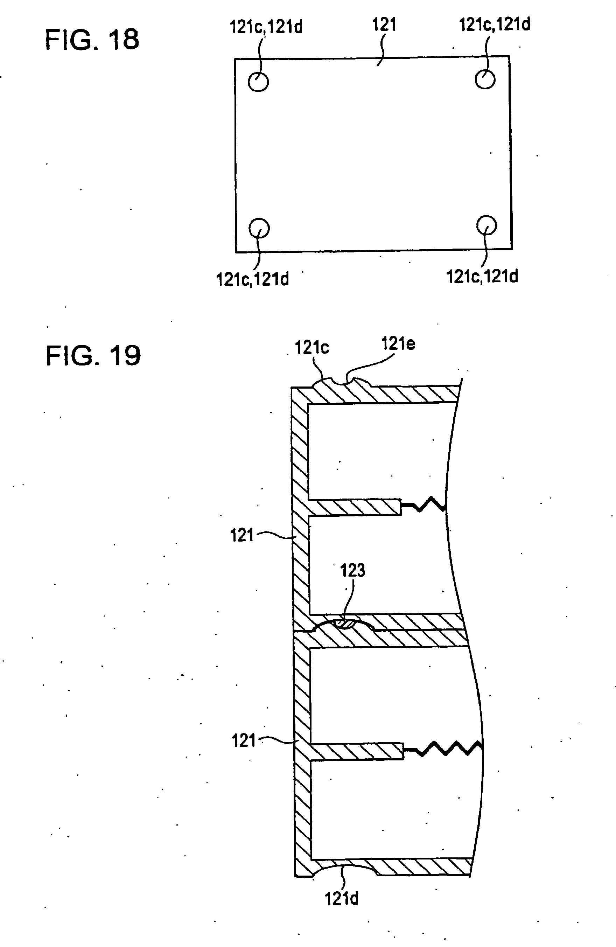

Figs. 17A and 17B illustrate the casing structure of a jet generator according to another embodiment of the present invention. This jet generator includes jet-generating units 120, as shown in Fig. 4, including casings 121 stacked on top of each other. Fig. 17B is an enlarged view of parts X, Y, and Z circled by the dotted lines in Fig. 17A. The jet-generating units 120 have bumps 121c on the top surfaces of the casings 121 and recesses 121d on the bottom surfaces of the casings 121. The bumps 121c and the recesses 121d are disposed in, for example, the vicinities of the four corners, as shown in Fig. 18. This structure allows the bumps 121c to engage with the recesses 121d so that the jet-generating units 120 can readily be stacked and aligned.

Although the four bumps 121c and the four recesses 121d are disposed on each casing 121 in Fig. 18, more or less than four bumps 121c and more or less than four recesses 121d may also be provided. If the bumps 121c and the recesses 121d are provided on, for example, all six surfaces of each casing 121, including the top and bottom surfaces thereof, the casings 121 can be arranged in every direction. This allows the casings 121 to be stacked on top of each other or to be readily arranged in a plane according to the shapes and positions of objects of interest, such as heat sources, to achieve, for example, effective heat dissipation.

The sizes and shapes of the bumps 121c and the recesses 121d are not limited to those in Figs. 17B and 18. Although the bumps 121c and the recesses 121d have a circular shape in Fig. 18, they may also have other shapes including a rectangular shape and an elongated rail shape.

Fig. 19 is a sectional view of the casings 121 shown in Fig. 17B according to a modification of the embodiment described above. In this modification, the bumps 121c each have a depression 121e which may be filled with, for example, a bonding material 123 such as an adhesive. These depressions 121e may also be disposed on other portions of the surfaces of the casings 121.

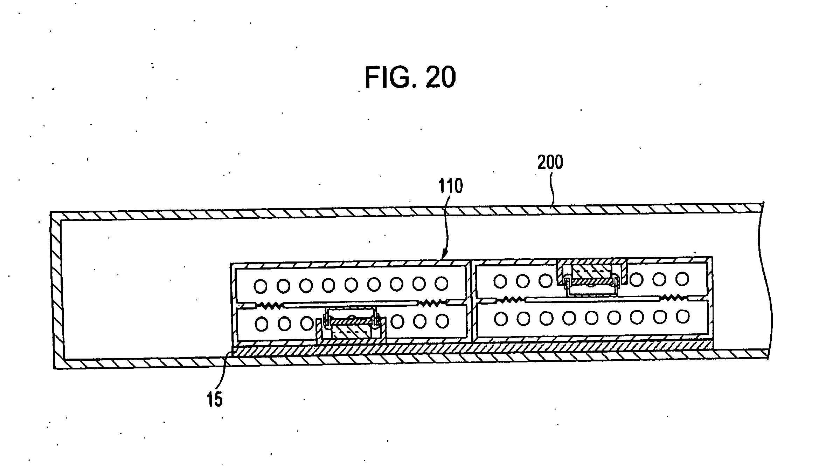

Fig. 20 is a sectional view of an electronic device including the jet generator 110 shown in Fig. 10 according to another embodiment of the present invention. In this embodiment, the jet generator 110 is attached to the inner bottom surface of a casing 200 of the electronic device, such as a PC, with a damping member 15 disposed therebetween to inhibit the transmission of vibration from the jet generator 110 to the casing 200. The damping member 15 may be formed of a material that can readily absorb vibration and impact, such as resin, rubber, and a low-repulsion material.

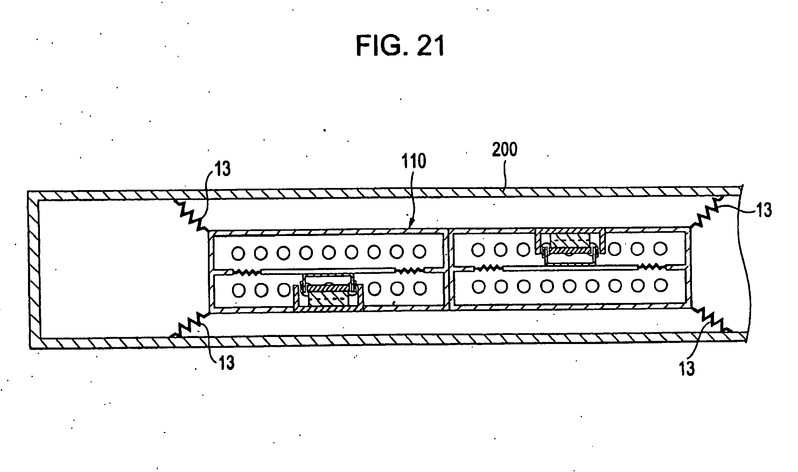

Alternatively, in Fig. 21, the casing 200 may have a suspension structure for elastically supporting the jet generator 110 with elastic members 13 formed of, for example, springs or rubber.

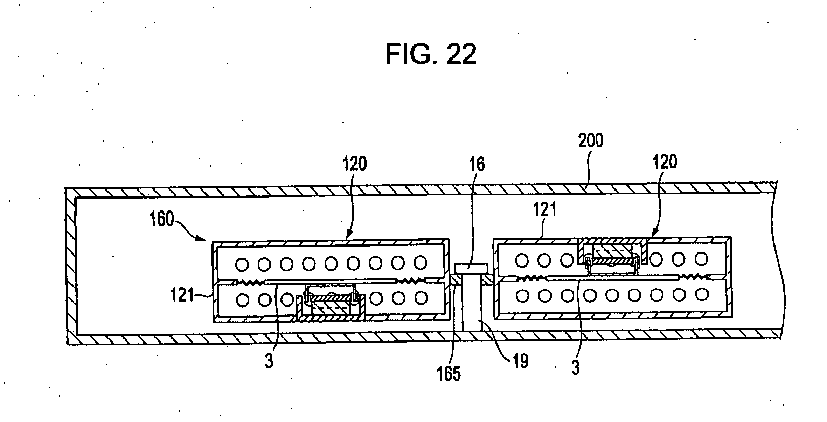

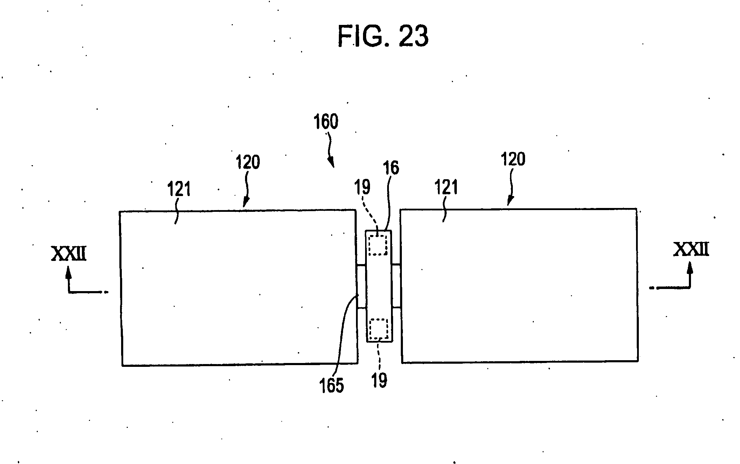

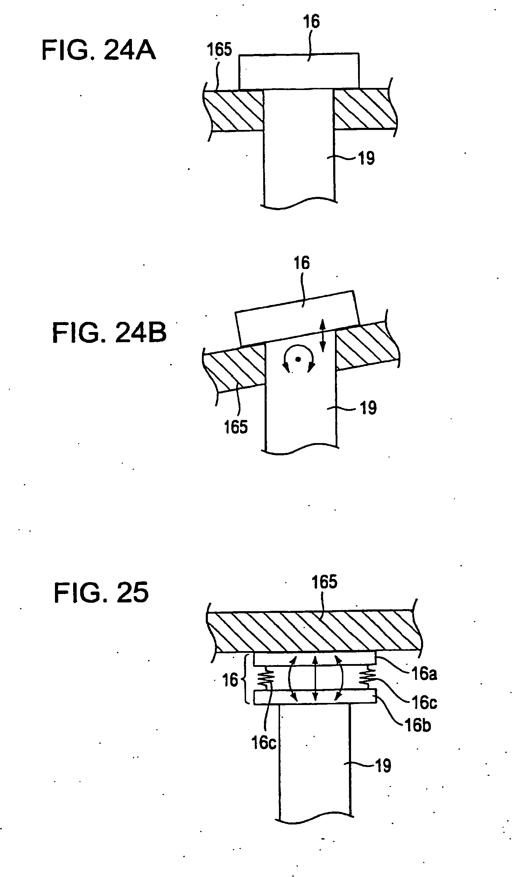

Fig. 22 illustrates a suspension structure of an electronic device according to another embodiment of the present invention. Fig. 23 is a plan view of a jet generator 160 shown in Fig. 22. Fig. 22 is a sectional view taken along line XXII-XXII in Fig. 23. This jet generator 160 includes two jet-generating units 120 including casings 121 coupled by a coupling member 165. Two pillars 19, for example, protrude from the inner bottom surface of a casing 200 of the electronic device. These pillars 19 support the jet-generating units 120 with a movable member 16 movably in the vertical direction and tiltably with respect to the horizontal direction (see Fig. 24B). The movable member 16 has elastic force in the vertical direction and the tilt direction (the rotation direction) indicated by the arrows shown in Fig. 24B. The coupling member 165 is fixed to the movable member 16 to prevent the jet generator 160 from coming into contact with the casing 200, that is, to suspend the jet generator 160 in the casing 200. The coupling member 165 may be integrally formed with the casings 121.

In Fig. 24A, for example, the two casings 121 (see Figs. 22 and 23) are in a horizontal position. When diaphragms 3 of the jet-generating units 120 are actuated, a moment acts on the overall the jet generator 160, as described in the embodiment shown in Fig. 10, to tilt the jet generator 160 in the rotation direction, as shown in Fig. 24B. The resulting vibration is then negligibly transmitted to the electronic device because the jet generator 160 is suspended.

Fig. 25 illustrates an example of the structure of the movable member 16. The movable member 16 includes, for example, two plates 16a and 16b stacked with springs 16c disposed therebetween. The coupling member 165 is fixed to the upper plate 16a so that the jet generator 160 can move in the vertical direction and the rotation direction.

Which structure has the best effect of attenuating the vibration of an electronic device among the structures shown in Figs. 20, 21, and 22 depends on various factors, including the size, shape, and weight of the electronic device; the size, shape, and weight of the jet generator used; and the direction of reciprocating motion and drive frequency of the diaphragms used.

The present invention is not limited to the embodiments described above, and various modifications are permitted.

Although the simple openings 1a to 1d are provided on the casing 1 in Figs. 1 and 2, nozzles may be attached to the openings 1a to 1d. The nozzles may then be integrally formed with the casing 1.

At least two of the features of the embodiments shown in the drawings may be used in any combination.

The jet generators described above may also be used to supply fuel to fuel cells. Specifically, the nozzles (or openings) of the jet generators according to the embodiments described above may be disposed opposite oxygen (air) inlets of fuel cell bodies. The jet generators can thus inject a jet into the inlets as an oxygen fuel.

It should be understood by those skilled in the art that various modifications, combinations, sub-combinations and alterations may occur depending on design requirements and other factors insofar as they are within the scope of the appended claims.

## Claims

1. A jet generator (10, 20, 30, 40, 50, 110) comprising:
at least one casing (1, 121, 221, 131, 231) containing a gas and having an opening (1a, 1b, 1c, 1d, 121a, 121b, 221a, 221b, 131a. 232a);
vibrators (3a, 3b, 3c, 3), wherein at least one of the vibrators (3a, 3b, 3c, 3, 33a, 33b) is attached to the at least one casing (10, 121, 221, 131, 231); and
actuators (5a, 5b, 5) for actuating the vibrators (3a, 3b, 3c, 3, 33a, 33b), thereby vibrating the gas to eject a pulsating jet thereof through the opening (1a, 1b, 1c, 1d, 121a, 121b, 221a. 221b), **characterized in that**
the vibrators (3a, 3b. 3c, 3, 33a, 33b) are so adjusted that the vibrational forces thereof attenuate each other.

2. The jet generator (10, 20, 30, 50) according to Claim 1, **characterized in that**
the vibrators (3a. 3b. 3c. 3) have the same size and shape, are formed of the same material, and vibrate with the same frequency; and **in that**
the actuators (5a, 5b. 5) actuate the vibrators (3a, 3b, 3c. 3) with a phase difference of substantially 360/n deg. from each other where n is the number of the vibrators (3a. 3b, 3).

3. The jet generator device (10, 20, 30, 40, 50) according to Claim 1, **characterized in that**
two (3a. 3b, 3c, 33a, 33b) of the vibrators face each other and are actuated by the actuators (5a, 5b. 5) so as to move toward and away from each other.

4. The jet generator (50) according to Claim 1, **characterized in that** the number of the vibrators (3a, 3b. 3c) is at least three;
the vibrators (3a, 3b. 3c) have the same size and shape, are formed of the same material, and vibrate with the same frequency:
a first vibrator group including at least two (3a, 3b) of the vibrators is actuated to vibrate at a first phase, the sum of the amplitudes of vibration of the first vibrator group being a first amplitude of vibration; and **in that**
at least one of the vibrators (3c) other than the first vibrator group is actuated to vibrate at a second phase opposite the first phase, the sum of the amplitude of vibration of the at least one vibrator (3c) being a second amplitude of vibration equal to the first amplitude of vibration.

5. The Jet generator (40) according to Claim 1, **characterized in that** at least two of the vibrators (33a. 33b) differ in at least one of size, shape, and material.

6. The Jet generator (20. 30, 40. 50, 110) according to Claim 1, **characterized In that** more than one casing (212. 221. 131, 231) is provided containing a gas, each having an opening (121a, 121b, 221a, 221b, 131a, 232a), wherein the vibrators (3. 33a. 33b, 3a, 3b, 3c) are attached to the Individual casings (212. 221, 131, 231) and the actuators (5) are disposed in the individual casings (212. 221, 131, 231) to actuate the vibrators (3, 33a. 33b. 3a. 3b, 3c).

7. The Jet generator (50) according to Claim 6, **characterized in that** the number of the vibrators (3a. 3b. 3c. 3d) is at least three;
a first vibrator group including at least two of the vibrators (3a. 3b, 3c. 3d) is actuated to vibrate at a first phase in a first direction; and
at least one of the vibrators (3b. 3c) other than the first vibrator group is actuated to vibrate at a second phase opposite the first phase in the first direction.

8. The jet generator (20, 30. 40. 50) according to Claim 6. **characterized in that**
the vibrators (3. 33a, 33b, 3a, 3b. 3c) are arranged to vibrate in the same direction; and
the casings (212. 221, 131, 231) are arranged in the vibration direction.

9. The jet generator (110) according to Claim 6, **characterized in that** the vibrators (3a. 3b. 3c, 3d) are arranged to vibrate in the same direction; and **in that**
the jet generator casings are arranged in a plane substantially perpendicular to the vibration direction.

10. The jet generator according to Claim 6, **characterized in that**
the casings (121) have engaging portions (121c, 121d) that engage with each other.

11. An electronic device comprising:
a heat source (95, 95a. 95b) and the jet generator of claim 1 for ejecting a pulsating Jet toward the heat source.

12. The electronic device according to Claim 11, **characterized by** further comprising a device casing (200) for accommodating the heat source, part (200a, 200b, 200c) of the device casing (200) partially or wholly constituting the jet generator casing.

13. The electronic device according to Claim 11, **characterized by** further comprising:
a device casing (200) for accommodating the heat source; and
a damping mechanism (15, 13) connected to the device casing (200) and the jet generator casing to absorb the vibration of the jet generator casing due to the vibration of the vibrators.

14. The electronic device according to Claim 13, **characterized in that** the damping mechanism includes a support mechanism (13) disposed in the electronic device casing (200), the support mechanism (13) elastically supporting the jet generator casing so as to absorb a residual force of the vibrational forces which tends to move the Jet generator casing.

15. The electronic device according to Claim 11, **characterized in that** more than one jet generator casing (121) is provided containing a gas, each having an opening, wherein the vibrators (3, 3a, 3b) are attached to the individual jet generator casings (121) and the actuators are disposed in the individual casings (121) to actuate the vibrators (3a. 3b, 3).

16. The electronic device according to Claim 15, **characterized by** further comprising:
a device casing (200) for accommodating the heat source: and
a damping mechanism (13, 15, 165. 16, 19) connected to the device casing (200) and at least one of the jet generator casings (121) to absorb the vibration of the jet generator casings (121) due to the vibration of the vibrators (3).

17. The electronic device according to Claim 16, **characterized in that** the damping mechanism includes:
a coupling member (165) coupling the jet generator casings (121); and
a support mechanism (16, 19) disposed in the device casing (200), the support mechanism (16, 16a, 16b, 16c, 19) elastically supporting the coupling member (165) so as to absorb a residual force of the vibrational forces which tends to move the jet generator casings (121).

## Patentansprüche

1. Strahlgenerator (10, 20, 30, 40, 50, 110), der enthält:
mindestens ein Gehäuse (1, 121, 221, 131, 231), das ein Gas enthält und eine Öffnung besitzt (1a, 1b, 1c, 1d, 121a, 121b, 221a, 221b, 131a, 232a);
Vibratoren (3a, 3b, 3c, 3), wobei mindestens einer der Vibratoren (3a, 3b, 3c, 3, 33a, 33b) an dem mindestens einen Gehäuse (10, 121, 221, 131, 231) befestigt ist; und
Aktuatoren (5a, 5b, 5) zum Betätigen der Vibratoren (3a, 3b, 3c, 3, 33a, 33b), wodurch das Gas vibriert wird, um einen pulsierenden Strahl davon durch die Öffnung (1a, 1b, 1c, 1d, 121a, 121b, 221a, 221b) auszustoßen, **dadurch gekennzeichnet, dass**
die Vibratoren (3a, 3b, 3c, 3, 33a, 33b) so eingestellt sind, dass sich deren Vibrationskräfte gegenseitig dämpfen.

2. Strahlgenerator (10, 20, 30, 50) nach Anspruch 1, **dadurch gekennzeichnet, dass** die Vibratoren (3a, 3b, 3c, 3) dieselbe Größe und Form aufweisen, aus demselben Material gebildet sind und mit derselben Frequenz vibrieren und dadurch, dass
die Aktuatoren (5a, 5b, 5) die Vibratoren (3a, 3b, 3c, 3) mit einer gegenseitigen Phasendifferenz von im Wesentlichen 360/n Grad betätigen, wobei n die Anzahl der Vibratoren (3a, 3b, 3) ist.

3. Strahlgeneratorvorrichtung (10, 20, 30, 40, 50) nach Anspruch 1, **dadurch gekennzeichnet, dass**
zwei (3a, 3b, 3c, 33a, 33b) der Vibratoren einander gegenüberliegen und durch die Aktuatoren (5a, 5b, 5) betätigt werden, um sich zueinander hin und voneinander weg zu bewegen.

4. Strahlgenerator (50) nach Anspruch 1, **dadurch gekennzeichnet, dass** die Anzahl der Vibratoren (3a, 3b, 3c) mindestens drei beträgt;
die Vibratoren (3a, 3b, 3c) dieselbe Größe und Form aufweisen, aus demselben Material gebildet sind und mit derselben Frequenz vibrieren;
eine erste Vibratorgruppe, die mindesten zwei (3a, 3b) der Vibratoren enthält, betätigt wird, um mit einer ersten Phase zu vibrieren, wobei die Summe der Vibrationsamplituden der ersten Vibratorgruppe eine erste Vibrationsamplitude darstellt; und dadurch, dass
mindestens einer der Vibratoren (3c) außerhalb der ersten Vibratorgruppe betätigt wird, um mit einer zu der ersten Phase entgegengesetzten zweiten Phase zu vibrieren, wobei die Summe der Vibrationsamplituden des mindestens einen Vibrators (3c) eine zweite Vibrationsamplitude ist, die gleich der ersten Vibrationsamplitude ist.

5. Strahlgenerator (40) nach Anspruch 1, **dadurch gekennzeichnet, dass** sich mindestens zwei der Vibratoren (33a, 33b) in Größe und/oder Form und/oder Material unterscheiden.

6. Strahlgenerator (20, 30, 40, 50, 110) nach Anspruch 1, **dadurch gekennzeichnet, dass** mehr als ein Gehäuse (212, 221, 131, 231), das ein Gas enthält, vorgesehen sind, wovon jedes eine Öffnung besitzt (121a, 121b, 221a, 221b, 131 a, 232a), worin die Vibratoren (3, 33a, 3a, 3b, 3c) an den einzelnen Gehäusen (212, 221, 131, 231) befestigt sind, und die Aktuatoren (5) in den einzelnen Gehäusen (212, 221, 131, 231) angeordnet sind, um die Vibratoren (3, 33a, 33b, 3a, 3b, 3c) zu betätigen.

7. Strahlgenerator (50) nach Anspruch 6, **dadurch gekennzeichnet, dass** die Anzahl der Vibratoren (3a, 3b, 3c, 3d) mindestens drei beträgt;
eine erste Vibratorgruppe, die mindestens zwei der Vibratoren (3a, 3b, 3c, 3d) enthält, betätigt wird, um in einer ersten Richtung mit einer ersten Phase zu vibrieren; und
mindestens einer der Vibratoren (3b, 3c) außerhalb der Vibratorgruppe betätigt wird, um mit einer zu der ersten Phase entgegengesetzten zweiten Phase in der ersten Richtung zu vibrieren.

8. Strahlgenerator (20, 30, 40, 50) nach Anspruch 6, **dadurch gekennzeichnet, dass**
die Vibratoren (3, 33a, 33b, 3a, 3b, 3c) angeordnet sind, um in derselben Richtung zu vibrieren, und
die Gehäuse (212, 221, 131, 231) in der Vibrationsrichtung angeordnet sind.

9. Strahlgenerator (110) nach Anspruch 6, **dadurch gekennzeichnet, dass**
die Vibratoren (3a, 3b, 3c, 3d) angeordnet sind, um in derselben Richtung zu vibrieren; und dadurch, dass
die Strahlgeneratorgehäuse in einer zu der Vibrationsrichtung im Wesentlichen senkrechten Ebene angeordnet sind.

10. Strahlgenerator nach Anspruch 6, **dadurch gekennzeichnet, dass**
die Gehäuse (121) ineinander greifende Abschnitte (121c, 121d), die ineinander greifen, besitzen.

11. Elektronische Vorrichtung, die enthält:
eine Wärmequelle (95, 95a, 95b) und den Strahlgenerator nach Anspruch 1 zum Ausstoßen eines pulsierenden Strahls in Richtung der Wärmequelle.

12. Elektronische Vorrichtung nach Anspruch 11, **dadurch gekennzeichnet, dass** sie ferner ein Vorrichtungsgehäuse (200) für die Aufnahme der Wärmequelle enthält, wobei ein Teil (200a, 200b, 200c) des Vorrichtungsgehäuses (200) teilweise oder vollständig das Strahlgeneratorgehäuse bildet.

13. Elektronische Vorrichtung nach Anspruch 11, **dadurch gekennzeichnet, dass** sie ferner enthält:
ein Vorrichtungsgehäuse (200) für die Aufnahme der Wärmequelle; und
einen Dämpfungsmechanimus (15, 13), der mit dem Vorrichtungsgehäuse (200) und dem Strahlgeneratorgehäuse verbunden ist, um die durch die Vibrationen der Vibratoren bedingten Vibrationen des Strahlgeneratorgehäuses zu absorbieren.

14. Elektronische Vorrichtung nach Anspruch 13, **dadurch gekennzeichnet, dass** der Dämpfungsmechanismus einen Tragmechanimus (13), der in dem Gehäuse (200) der elektronischen Vorrichtung angeordnet ist, enthält, wobei der Tragmechanismus (13) das Strahlgeneratorgehäuse elastisch trägt, um eine verbleibende Kraft der Vibrationskräfte, die bestrebt ist, das Strahlgeneratorgehäuse zu bewegen, zu absorbieren.

15. Elektronische Vorrichtung nach Anspruch 11, **dadurch gekennzeichnet, dass** mehr als ein Strahlgeneratorgehäuse (121), das ein Gas enthält, vorgesehen sind, wovon jedes eine Öffnung besitzt, worin die Vibratoren (3, 3a, 3b) an den einzelnen Strahlgeneratorgehäusen (121) angebracht sind, und die Aktuatoren in den einzelnen Gehäusen (121) angeordnet sind, um die Vibratoren (3a, 3b, 3) zu betätigen.

16. Elektronische Vorrichtung nach Anspruch 15, **dadurch gekennzeichnet, dass** sie ferner enthält:
ein Vorrichtungsgehäuse (200) für die Aufnahme der Wärmequelle; und
einen Dämpfungsmechanismus (13, 15, 165, 16, 19), der mit dem Vorrichtungsgehäuse (200) und mindestens einem Strahlgeneratorgehäuse (121) verbunden ist, um die durch die Vibrationen der Vibratoren (3) bedingten Vibrationen des Strahlgeneratorgehäuses (121) zu absorbieren.

17. Elektronische Vorrichtung nach Anspruch 16, **dadurch gekennzeichnet, dass** der Dämpfungsmechanismus enthält:
ein Kopplungselement (165), das die Strahlgeneratorgehäuse (121) koppelt; und
einen Tragmechanismus (16, 19), der in dem Vorrichtungsgehäuse (200) angeordnet ist, wobei der Tragmechanismus (16, 16a, 16b, 16c, 19) das Kopplungselement elastisch trägt, um eine verbleibende Kraft der Vibrationskräfte, die bestrebt ist, das Strahlgeneratorgehäuse (121) zu bewegen, zu absorbieren.

## Revendications

1. Générateur de jet (10, 20, 30, 40, 50, 110) comprenant :
au moins un boîtier (1, 121, 221, 131, 231) contenant un gaz et ayant une ouverture (1a, 1b, 1c, 1d, 121a, 121b, 221a, 221b, 131a, 232a) ;
des vibrateurs (3a, 3b, 3c, 3), dans lequel au moins l'un des vibrateurs (3a, 3b, 3c, 3, 33a, 33b) est fixé sur le au moins un boîtier (10, 121, 221, 131, 231) ; et
des actionneurs (5a, 5b, 5) pour actionner les vibrateurs (3a, 3b, 3c, 3, 33a, 33b), faisant ainsi vibrer le gaz pour éjecter son jet pulsé par l'ouverture (1a, 1b, 1c, 1d, 121a, 121b, 221b, 221a, 221b), **caractérisé en ce que** :
les vibrateurs (3a, 3b, 3c, 3, 33a, 33b) sont ajustés de sorte que leurs forces de vibration s'atténuent entre elles.

2. Générateur de jet (10, 20, 30, 50) selon la revendication 1, **caractérisé en ce que** les vibrateurs (3a, 3b, 3c, 3) ont la même taille et la même forme, sont formés avec le même matériau et vibrent avec la même fréquence ; et **en ce que** :
les actionneurs (5a, 5b, 5) actionnent les vibrateurs (3a, 3b, 3c, 3) avec une différence de phase sensiblement de 360/n deg. les uns par rapport aux autres, où n est le nombre de vibrateurs (3a, 3b, 3).

3. Générateur de jet (10, 20, 30, 40, 50) selon la revendication 1, **caractérisé en ce que** :
deux (3a, 3b, 3c, 33a, 33b) des vibrateurs se font face et sont actionnés par les actionneurs (5a, 5b, 5) afin de se rapprocher et de s'éloigner l'un de l'autre.

4. Générateur de jet (50) selon la revendication 1, **caractérisé en ce que** le nombre de vibrateurs (3a, 3b, 3c) est au moins de trois ;
les vibrateurs (3a, 3b, 3c) ont la même taille et la même forme, sont formés avec le même matériau et vibrent avec la même fréquence ;
un premier groupe de vibrateurs comprenant au moins deux (3a, 3b) des vibrateurs, est actionné pour vibrer à une première phase, la somme des amplitudes de vibration du premier groupe de vibrateurs étant une première amplitude de vibration ; et **en ce que** :
au moins l'un des vibrateurs (3c) différent du premier groupe de vibrateurs est actionné pour vibrer à une seconde phase opposée à la première phase, la somme de l'amplitude de vibration du au moins un vibrateur (3c) étant une seconde amplitude de vibration égale à la première amplitude de vibration.

5. Générateur de jet (40) selon la revendication 1, **caractérisé en ce qu'**au moins deux des vibrateurs (33a, 33b) diffèrent selon au moins un élément parmi la taille, la forme et le matériau.

6. Générateur de jet (20, 30, 40, 50, 110) selon la revendication 1, **caractérisé en ce que** l'on prévoit plus d'un boîtier (212, 221, 131, 231) contenant un gaz, chacun ayant une ouverture (121a, 121b, 221a, 221b, 131a, 232a), dans lequel les vibrateurs (3, 33a, 33b, 3a, 3b, 3c) sont fixés sur les boîtiers (212, 221, 131, 231) individuels et les actionneurs (5) sont disposés dans les boîtiers (212, 221, 131, 231) individuels pour actionner les vibrateurs (3, 33a, 33b, 3a, 3b, 3c).

7. Générateur de jet (50) selon la revendication 6, **caractérisé en ce que** :
le nombre de vibrateurs (3a, 3b, 3c, 3d) est au moins de trois ;
un premier groupe de vibrateurs comprenant au moins deux des vibrateurs (3a, 3b, 3c, 3d), est actionné pour vibrer à une première phase dans une première direction ; et
au moins l'un des vibrateurs (3b, 3c) différent du premier groupe de vibrateurs, est actionné pour vibrer à une seconde phase opposée à la première phase dans la première direction.

8. Générateur de jet (20, 30, 40, 50) selon la revendication 6, **caractérisé en ce que** :
les vibrateurs (3, 33a, 33b, 3a, 3b, 3c) sont agencés pour vibrer dans la même direction ; et
les boîtiers (212, 221, 131, 231) sont agencés dans la direction de vibration.

9. Générateur de jet (110) selon la revendication 6, **caractérisé en ce que** les vibrateurs (3a, 3b, 3c, 3d) sont agencés pour vibrer dans la même direction ; et **en ce que** :
les boîtiers de générateur de jet sont agencés dans un plan sensiblement perpendiculaire à la direction de vibration.

10. Générateur de jet selon la revendication 6, **caractérisé en ce que** :
les boîtiers (121) ont des parties de mise en prise (121c, 121d) qui se mettent en prise entre elles.

11. Dispositif électronique comprenant :
une source de chaleur (95, 95a, 95b) et le générateur de jet selon la revendication 1 pour éjecter un jet pulsé vers la source de chaleur.

12. Dispositif électronique selon la revendication 11, **caractérisé en ce qu'**il comprend en outre, un boîtier de dispositif (200) pour loger la source de chaleur, la partie (200a, 200b, 200c) du boîtier de dispositif (200) constituant tout ou partie du boîtier de générateur de jet.

13. Dispositif électronique selon la revendication 11, **caractérisé en ce qu'**il comprend en outre :
un boîtier de dispositif (200) pour loger la source de chaleur ; et
un mécanisme d'amortissement (15, 13) raccordé au boîtier de dispositif (200) et au boîtier de générateur de jet pour absorber la vibration du boîtier de générateur de jet due à la vibration des vibrateurs.

14. Dispositif électronique selon la revendication 13, **caractérisé en ce que** le mécanisme d'amortissement comprend un mécanisme de support (13) disposé dans le boîtier de dispositif électronique (200), le mécanisme de support (13) supportant élastiquement le boîtier de générateur de jet pour absorber une force résiduelle des forces de vibration qui a tendance à déplacer le boîtier de générateur de jet.

15. Dispositif électronique selon la revendication 11, **caractérisé en ce que** l'on prévoit plus d'un boîtier de générateur de jet (121) contenant un gaz, chacun ayant une ouverture, dans lequel les vibrateurs (3, 3a, 3b) sont fixés sur les boîtiers de générateur de jet (121) individuels et les actionneurs sont disposés dans les boîtiers (121) individuels pour actionner les vibrateurs (3a, 3b, 3).

16. Dispositif électronique selon la revendication 15, **caractérisé en ce qu'**il comprend en outre :
un boîtier de dispositif (200) pour loger la source de chaleur ; et
un mécanisme d'amortissement (13, 15, 165, 16, 19) raccordé au boîtier de dispositif (200) et au moins l'un des boîtiers de générateur de jet (121) pour absorber la vibration des boîtiers de générateur de jet (121) due à la vibration des vibrateurs (3).

17. Dispositif électronique selon la revendication 16, **caractérisé en ce que** le mécanisme d'amortissement comprend :
un élément de couplage (165) couplant les boîtiers de générateur de jet (121) ; et
un mécanisme de support (16, 19) disposé dans le boîtier de dispositif (200), le mécanisme de support (16, 16a, 16b, 16c, 19) supportant élastiquement l'élément de couplage (165) afin d'absorber une force résiduelle des forces de vibration qui a tendance à déplacer les boîtiers de générateur de jet (121).
